# EUROPEAN PATENT APPLICATION

(11) **EP 2 466 628 A1**
(43) Date of publication of application: **20.06.2012**
(21) Application number: 10195459.2
(22) Date of filing: 16.12.2010
(51) Int. Cl.: H01L 21/331, H01L 29/737

(54) **Bipolar transistor manufacturing method and bipolar transistor**

(71) Applicant: NXP B.V., 5656 AG Eindhoven (NL)
(72) Inventor: Donkers, Johannes, Redhill, Surrey RH1 1DL (GB); Vanhoucke, Tony, Redhill, Surrey RH1 1DL (GB); Magnee, Petrus, Redhill, Surrey RH1 1DL (GB); Duriez, Blandine, Redhill, Surrey RH1 1DL (GB); Klaassen, Dirk, Redhill, Surrey RH1 1DL (GB)
(74) Representative: Hardingham, Christopher Mark

(57) **Abstract**

Disclosed is a method of manufacturing a bipolar transistor, comprising providing a substrate (10) comprising a first isolation region (12) separated from a second isolation region by an active region (11) comprising a collector impurity; forming a layer stack over said substrate, said layer stack comprising a base layer (14, 14'), an etch protection portion (30, 32, 34) covering the base layer over the active region, a polysilicon layer (16) over said base layer and etch protection portion and an insulating layer (18) over the polysilicon layer; forming a emitter window (40) in said layer stack, said emitter window exposing at least part of said active region; oxidizing the exposed regions (16') of the polysilicon layer in the emitter window; removing the etch protection portion; forming sidewall spacers (22) in the base window; and filling the base window with an emitter material (24). A bipolar transistor manufactured in accordance with this method is also disclosed.

## Description

### FIELD OF THE INVENTION

The present invention relates to a method of manufacturing a bipolar transistor, comprising providing a substrate comprising a first isolation region separated from a second isolation region by an active region comprising a collector impurity; forming a layer stack over said substrate, said layer stack comprising a base layer, an etch protection portion covering the base layer over the active region, a polysilicon layer over said base layer and etch protection portion and an insulating layer over the polysilicon layer; and forming a base window in said layer stack, said base window exposing at least part of said active region.

The present invention further relates to a bipolar transistor manufactured in accordance with this method.

### BACKGROUND OF THE INVENTION

Nowadays, many electronic devices incorporate functionality that operates at radio frequencies, such as mobile communication devices. The implementation of such functionality in a cost-effective manner is far from trivial. It is well-known that bipolar transistors are particularly suitable for handling signals in the radio frequency (RF) domain. However, the manufacture of integrated circuits (ICs) based on silicon bipolar transistor technology is more costly than for instance complementary metal oxide semiconductor (CMOS) ICs, and the downscaling of the device feature size is more easily achieved in CMOS technology. The cost-effective nature of CMOS technology has led to the acceptance of CMOS technology as the mainstream technology of choice for the manufacture of a wide variety of semiconductor components including ICs.

However, the breakdown characteristics of CMOS transistors limit the usefulness of CMOS transistors in RF applications unless costly measures are implemented in the CMOS process to improve these characteristics. Such costly measures typically prohibit the use of RF-CMOS technologies for manufacturing small volume devices such as analog mixed signal (AMS) devices. For these reasons, efforts have been made to produce bipolar transistors using a CMOS process flow, thereby providing mixed technology ICs in which bipolar transistors can be used for handling RF signals. An example of such an IC is provided in WO2010/066630 A1.

The challenge that process developers face is that the number of alterations to the CMOS process should remain small whilst at the same time yielding good quality bipolar transistors that are capable of handling high frequency signals. An example of a low-complexity IC including a heterojunction bipolar transistor formed in a CMOS process flow can for instance be found in WO 2003/100845 A1.

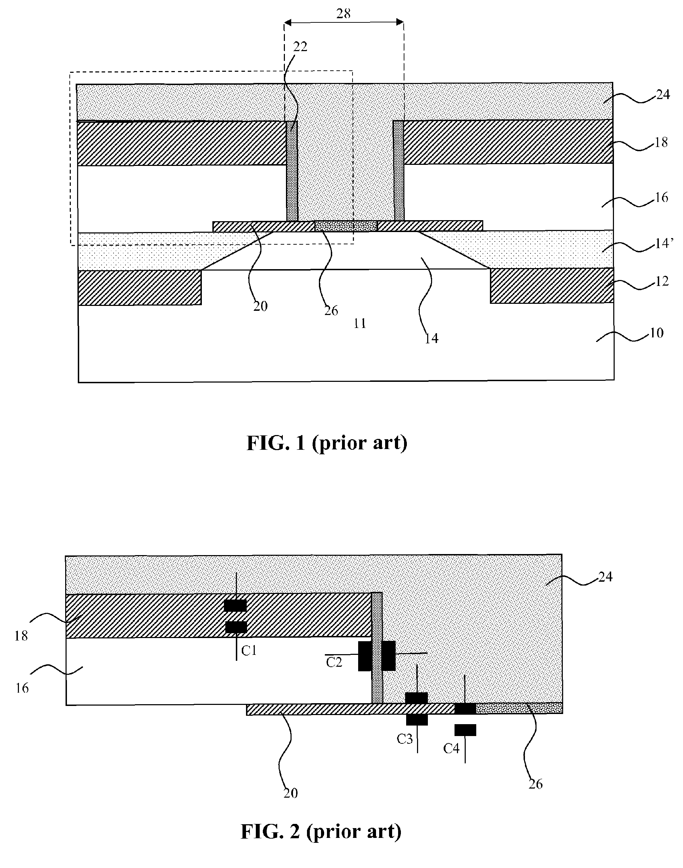

It however remains a challenge to improve the design of bipolar transistors, and in particular bipolar transistors manufactured in CMOS manufacturing processes such that the maximum operating frequency of the bipolar transistor can be further increased, e.g. by minimizing the noise figure of the bipolar transistor, as will be explained in more detail with the aid of FIG. 1 and FIG. 2, which shows the detail indicated by the dashed box in FIG. 1.

The bipolar transistor shown in FIG. 1 comprises a silicon substrate 10 including an active region 11 in which the collector of the bipolar transistor is formed, e.g. by provision of a buried layer in the substrate 10 or by implantation of an impurity into the substrate 10. The active region 11 is defined in between isolation regions 12, e.g. shallow trench isolation (STI) regions. The bipolar transistor further comprises a layer stack including an epitaxially grown base layer, which grows as a monocrystalline region 14 over the silicon substrate 10 and as a polycrystalline region 14' over the isolation regions 12. A nitride layer (not shown) may be present on the isolation regions 12 to promote epitaxial growth of the base layer portion 14'. A polysilicon base contact layer 16 is present on the base layer, which is covered by an electrically insulating layer 18. An emitter window 28 is defined over the active region 11, in which an emitter material 24 is formed, e.g. As-doped polysilicon, which is electrically insulated from the base contact layer 16 by sidewall spacers 22 in the emitter window 28 and by the electrically insulating layer 18 for the emitter material 24 deposited outside the emitter window 28, e.g. the emitter contact. The emitter material 24 is electrically insulated from the intrinsic base region 14 by further electrically insulation portions 20. The outdiffusion 26 of the emitter 24 is surrounded by these portions 20.

It has been found by the present inventors that emitter-base capacitance reduction is important for noise and frequency improvement. The various contributions to the total emitter-base capacitance (C_{BE}) are shown in FIG. 2. It has been found that four main contributions can be identified:
C1: emitter 24 to base contact 16 through the insulating layer 18;
C2: emitter 24 to base contact 16 through the sidewall spacer 22;
C3: emitter 24 to intrinsic base 14 through insulator 20; and
C4 outdiffusion 26 to intrinsic base 14.

It has also been found that C2 dominates C_{BE} at low voltages, and still accounts for around 10-20% at high voltages, e.g. V_{BE} = 850 mV. Consequently, C2 not only has a large influence on the minimum noise figure situated at currents well below peak f_{T} currents, but also on the higher current region closer to peak f_{T}. Consequently, both the noise figure and the RF performance can be improved by reducing C2. However, increasing the thickness of the sidewall spacers 22 to reduce C2 reduces the width of the emitter 24, which negatively affects, i.e. reduces, the power density capabilities of the bipolar transistor.

### SUMMARY OF THE INVENTION

The present invention seeks to provide a method of manufacturing a bipolar transistor in which the lateral base contact to emitter capacitance can be reduced without affecting emitter dimensions.

The present invention further seeks to provide such a bipolar transistor.

In accordance with a first embodiment, there is provided a method of manufacturing a bipolar transistor, comprising providing a substrate comprising a first isolation region separated from a second isolation region by an active region comprising a collector impurity; forming a layer stack over said substrate, said layer stack comprising a base layer, an etch protection portion covering the base layer over the active region, a polysilicon layer over said base layer and etch protection portion and an insulating layer over the polysilicon layer; forming a base window in said layer stack, said base window exposing at least part of said active region; oxidizing the exposed regions of the polysilicon layer in the base window; removing the etch protection portion; forming sidewall spacers in the base window; and filling the base window with an emitter material.

By oxidizing the exposed base poly inside the base window, the thickness of the lateral electric insulation between the base poly and the emitter material is increased, thereby reducing the lateral parasitic capacitance C2 between the base poly and the emitter material, as well as the vertical parasitic capacitance C1, which improves the noise figure and the maximum operating frequency of the bipolar transistor without affecting base window dimensions.

In a preferred embodiment, said etch protection portion comprises a nitride layer, as a nitride layer is particularly suitable for providing protection against oxidation enhanced diffusion effects on the doping profile in the intrinsic base 14 during the necessary oxidation step. The nitride layer may for instance form part of an ONO (oxide-nitride-oxide) stack over the intrinsic base.

Advantageously, the step of forming a base layer comprises epixially growing a first undoped Si layer over the substrate; an undoped SiGe:C collector-base spacer on the first undoped Si layer; a boron-doped SiGe:C base on the collector-base spacer; an undoped SiGe:C base-emitter spacer on the base; and a doped Si emitter cap on the base-emitter spacer. Such a base layer stack is known to improve high frequency characteristics of the bipolar transistor.

A patterned nitride layer may be formed over the substrate prior to the formation of the layer stack, said patterned nitride layer leaving the active region exposed, to promote epitaxial growth over the isolation regions in the substrate.

A suitable oxidation step is a wet oxidation recipe at a temperature in the range of 700-750°C. The shape of the oxide portions in the base polysilicon layer may be vary between a half moon shape and a rectangular shape, which can be controlled by suitable adjustment of the oxidation conditions.

Due to the formation of the oxidized portion of the polysilicon base contact layer inside the base window, the thickness of the sidewall spacers may be reduced. Furthermore, the step of forming sidewall spacers may be simplified to consist of depositing oxide spacers only in the base window.

In accordance with another aspect of the present invention, there is provided a bipolar transistor comprising a substrate including a first isolation region separated from a second isolation region by an active region comprising a collector impurity; and a layer stack over said substrate, said layer stack comprising a base layer, a polysilicon layer over said base layer and an insulating layer over the polysilicon layer, said layer stack comprising a base window over the active region filled with an emitter material, the emitter material being separated from the layer stack by sidewall spacers, wherein the regions of the polysilicon layer facing the base window have been oxidized.

Such a bipolar transistor benefits from improved noise figure and high frequency characteristics due to its reduced base emitter capacitance as previously explained. Preferably, the emitter material comprises doped polysilicon, such as As-doped polysilicon.

The bipolar transistor of the present invention may be advantageously integrated in an integrated circuit (IC), such as an IC manufactured in CMOS technology. Such an IC has an improved suitability for use in high frequency (e.g. RF) application domains.

### BRIEF DESCRIPTION OF THE EMBODIMENTS

Embodiments of the invention are described in more detail and by way of non-limiting examples with reference to the accompanying drawings, wherein
FIG. 1 schematically depicts a prior art bipolar transistor design;
FIG. 2 schematically depicts the various contributions to the CBE of the bipolar transistor design of FIG. 1;
FIG. 3-8 schematically depict various stage of an embodiment of the method of the present invention;
FIG. 9 schematically depicts the influence of an embodiment of the present invention on the noise figure of a bipolar transistor at 10GHz; and
FIG. 10 schematically depicts the influence of an embodiment of the present invention on the power dissipation of a bipolar transistor at minimum noise figure operation.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

The method of the present invention may be applied to the manufacture of any suitable bipolar transistor. An embodiment of the manufacturing method of the present invention will now be explained in more detail for a particular heterojunction bipolar transistor by way of non-limiting example only. The skilled person will understand that the principles of the present invention may be applied to any bipolar transistor design that comprises a vertical layer stack in which an emitter is laterally separated from a polysilicon base layer, as will become apparent from the following description.

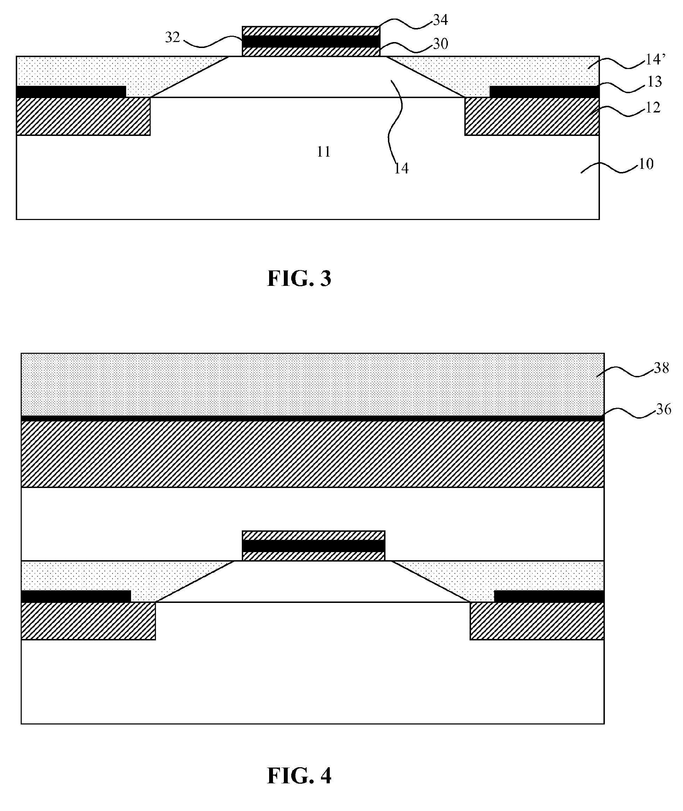

A possible starting point of the method of the present invention is shown in FIG. 3. A substrate 10 including an active region 11 in between isolation regions 12 such as shallow trench isolation regions is provided. The active region typically comprises a collector region, e.g. a buried collector formed by a buried layer grown epitaxially in the substrate 10 or an implanted collector. Any suitable implementation of the collector may be contemplated. A patterned nitride layer 13 may optionally be formed over the isolation regions 12, whilst leaving exposed the active region 11. On this structure, a base layer may be epitaxially grown, resulting in monocrystalline base layer portions 14 growing on the exposed regions of the monocrystalline substrate 10 including the active region 11 and polycrystalline base layer portions 14' on amorphous or polycrystalline surfaces such as the isolation regions 12 and the nitride layer 13 if present.

In a preferred embodiment, the base layer comprises a Si/SiGe:C layer stack, which by way of non-limiting example may be formed as follows. Prior to the growth of the epitaxial base layer, the exposed silicon surfaces may be passivated by a hydrogen bake. The base layer is formed by first growing an undoped Si buffer layer, followed by the growth of an undoped SiGe:C collector-base spacer, a boron-doped SiGe:C base, an undoped SiGe:C base-emitter spacer and a doped Si emitter cap. The carbon content in the SiGe layers preferably is around 0.2% and the germanium content is preferably around 20% in these layers. The carbon in the SiGe:C layers prevents the outdiffusion of boron impurities from the boron-doped base, as is known per se. However, it should be understood that the exact composition and structure of the base in the bipolar transistor of the present invention is not important; any suitable base construction may be chosen.

After the formation of the base layer, an etch protection layer is formed over the intrinsic base layer portion 14, to protect the base layer portion 14 from etch recipes capable of oxidizing silicon. Such an etch protection layer may be formed by depositing the layer over the base layer and subsequently patterning the etch protection layer to its desired dimensions, e.g. by forming a patterned mask over the etch protection layer, removing the exposed parts of the etch protection layer and subsequently removing the mask. Such patterning is well-known to the skilled person and has not been explained in further detail for this reason. The etch protection layer preferably comprises a nitride portion 32, as nitride is known to be highly resistant to oxidation enhanced diffusion of the impurities in the intrinsic base layer, e.g. boron impurities. In a non-limiting example of the present invention, the etch protection layer comprises an ONO layer stack formed of a first oxide layer 30, a nitride layer 32 and a second oxide layer 34. The oxide layers 30 and 34 may be any suitable type of oxide, e.g. SiO₂ or TEOS. The nitride layer 32 preferably has a thickness of about 10 nm, as at this thickness the outdiffusion of the base layer impurities is effectively prevented. The thickness of the oxide layers 30 and 34 may be separately optimized.

The method proceeds as shown in FIG. 4, in which a polysilicon base contact layer 16 is grown over the resultant structure in any suitable manner, e.g. by means of a suitable vapor deposition process such as CVD, followed by the formation of an electrically insulating layer 18, which may be any suitable dielectric material, e.g. TEOS. An etch resist layer such as a nitride layer 36 may be formed over the electrically insulating layer 18 to protect the layer from etch damage during further processing steps. A standard photo resist material 38 is deposited over the nitride layer 36.

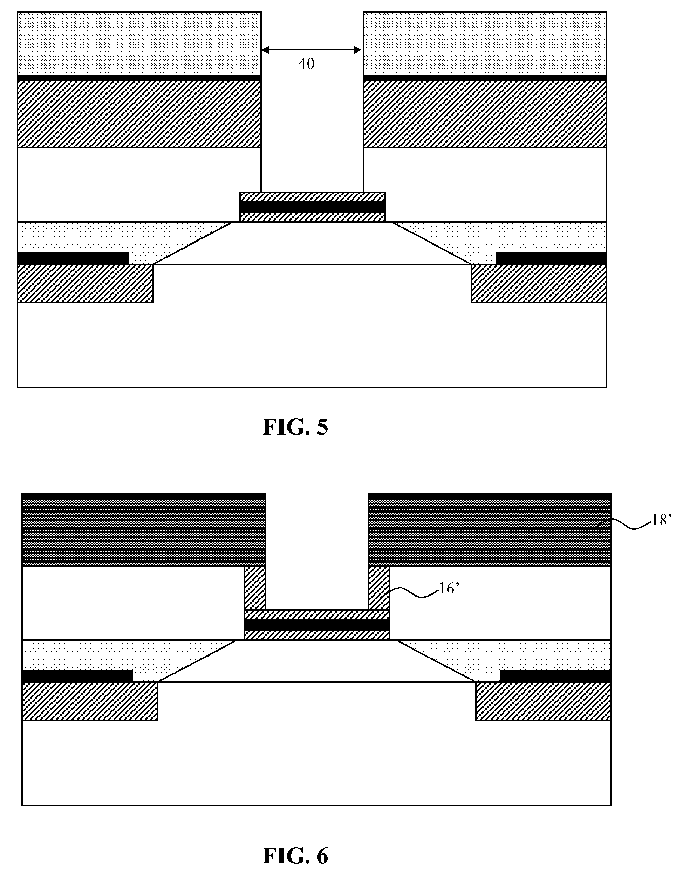

As shown in FIG. 5, the photo resist 38 is used to define an emitter window over the active region 11. The emitter window 40 is subsequently etched in the layer stack over the substrate 10. The emitter window opens a region above the active region 11 and is terminated on the etch protection layer formed by the ONO stack including oxide layer 30, nitride layer 32 and oxide layer 34. In an embodiment, the base window etch is performed using a number of selective etch steps to selectively remove the nitride layer 36, a selective etch to remove the dielectric or insulating layer 18, e.g. by using a selective oxide etch followed by a selective etch to remove the polysilicon base contact layer 16, e.g. using a poly-Si etch recipe including CF₄, Cl₂, HBr and O₂.

Next, as shown in FIG. 6, the resultant structure is subjected to a silicon oxidation step, thereby oxidizing portions 16' of the polysilicon base contact layer 16 that are exposed inside the base window 40. It is preferred to oxidize the portions 16' of the polysilicon layer 16 by means of a wet oxidation step performed at a temperature in the range of 700-750°C. For instance, H₂O may be used to oxidize TEOS at this temperature. Other suitable etch recipes will be apparent to the skilled person. At this temperature, boron diffusion from the extrinsic base portions 14' is negligible and the TEOS layer 18 is effectively converted into a densified TEOS layer 18', i.e. substantially converted into a SiO₂ layer.

The oxidized portions 16' of the polysilicon base contact layer 16 increase the lateral electrical insulation between the polysilicon base contact layer 16 and the emitter to be formed in the base window 40. The oxidized portions 16' ideally have a rectangular shape as this maximizes the electrical insulation between emitter and base although any shape in between a rectangular shape and a half moon or 'D'-shape for the oxidized portions 16' is acceptable. It has been found that a lateral thickness of 50 nm can be easily achieved for the oxidized portions 16', thereby significantly increasing the lateral electrical insulation between the emitter and the extrinsic base without affecting emitter width.

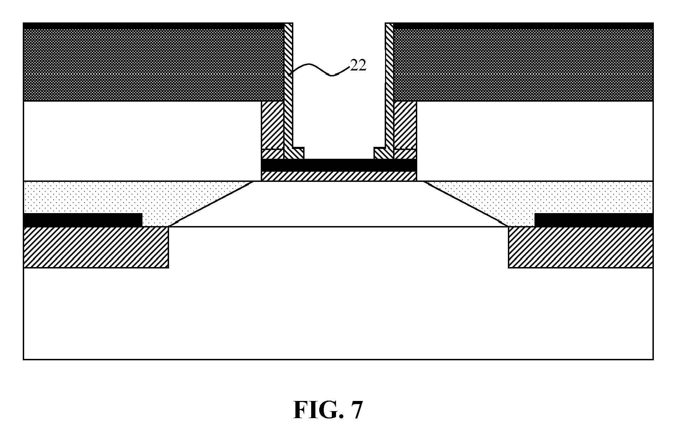

Next the sidewall spacers 22 are formed in the emitter window 40 as shown in FIG. 7. As part of the function of the sidewall spacers 22 is to electrically insulate the emitter from the extrinsic base, it will be apparent that due to the presence of the oxidized portions 16' of the polysilicon base contact layer 16 the thickness of the sidewall spacers 22 may be reduced. Whereas regularly an ONO stack and an amorphous silicon layer is deposited inside the base window 40, the ONO stack may be replaced by a single thin oxide layer to form the sidewall spacers 22, as the necessary electrical insulation between the emitter and extrinsic base no longer is solely provided by the sidewall spacers 22, but is now largely provided by the oxidized portions 16' of the polysilicon base contact layer 16.

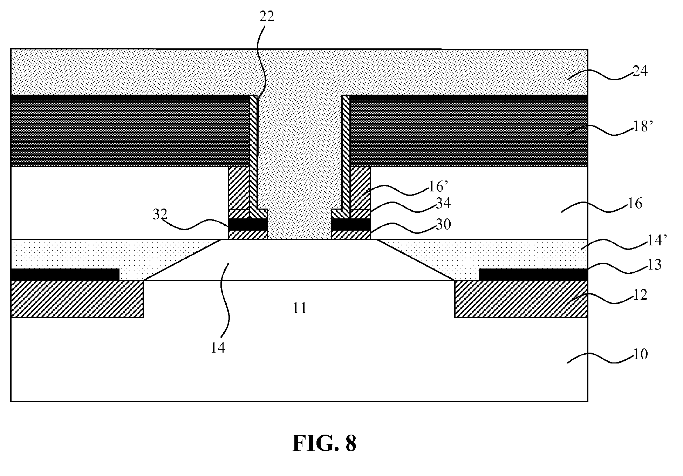

The bipolar transistor may now be completed in any suitable manner, e.g. by the deposition of an emitter material 24 over the resultant structure as shown in FIG. 8, e.g. an As-doped polysilicon emitter material 24, after which conventional patterning and contact formation steps may be performed to complete the manufacture of the bipolar transistor. Prior to the deposition of the emitter material 24, the exposed part of etch stop layer formed by way of non-limiting example by the ONO stack of oxide layer 30, nitride layer 32 and oxide layer 34 is removed from the bottom of the base window 40, using any suitable etch recipe. Any suitable manner to complete the bipolar transistor manufacture may be chosen. As such completion steps are entirely routine to the skilled person they have not been shown for the sake of brevity only.

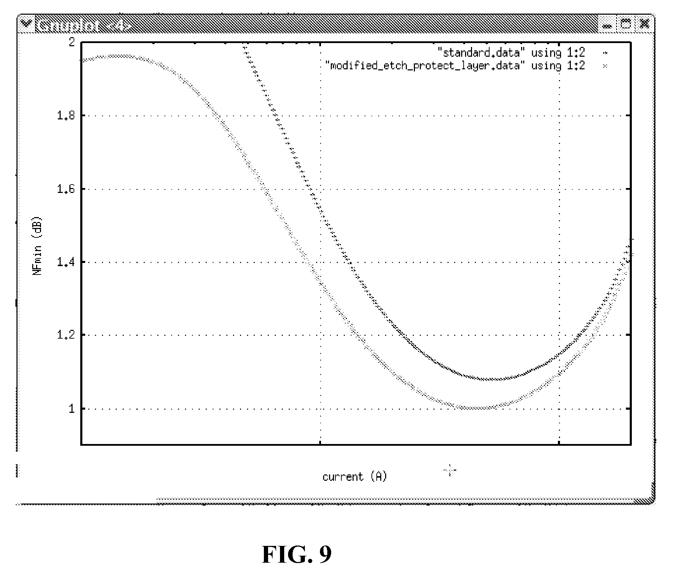

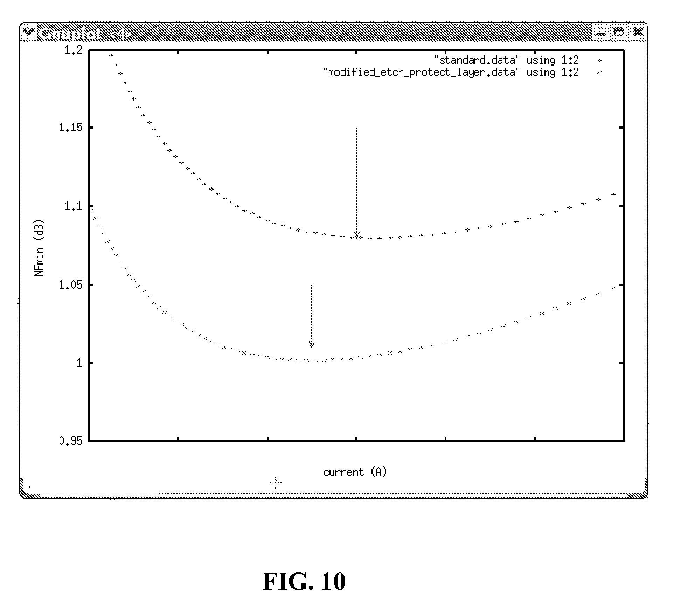

FIG. 9 shows the simulated effect of the inclusion of the oxidized portions 16' in the design of a 0.25 * 0.25 µm² device on the minimum noise figure NFₘᵢₙ (dB) at 10 GHz. The darker line shows the noise figure characteristics of a bipolar transistor device without oxidized portions 16' in the polysilicon base contact layer 16, in which the lateral dimension of the dielectric layer between the emitter 24 and the polysilicon base contact layer 16 is 4 nm, whereas the lighter line shows the noise figure characteristics of a bipolar transistor device including oxidized portions 16', in which the lateral dimension of the dielectric layer between the emitter 24 and the polysilicon base contact layer 16 is 50 nm. It is immediately apparent that the reduction of C2 as shown in FIG. 2 causes a marked improvement on the minimum noise figure of the bipolar transistor. FIG. 10 shows the effect the noise figure has on the power dissipation of the bipolar transistor without oxidized portions 16' (dark line) and with oxidized portions 16' (light line). The lower NFₘᵢₙ clearly leads to a marked reduction in the power dissipation of the bipolar transistor.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of manufacturing a bipolar transistor, comprising:
providing a substrate (10) comprising a first isolation region (12) separated from a second isolation region by an active region (11) comprising a collector impurity;
forming a layer stack over said substrate, said layer stack comprising a base layer (14, 14'), an etch protection portion (30, 32, 34) covering the base layer over the active region, a polysilicon layer (16) over said base layer and etch protection portion and an insulating layer (18) over the polysilicon layer;
forming a emitter window (40) in said layer stack, said emitter window exposing at least part of said active region;
oxidizing the exposed regions (16') of the polysilicon layer in the emitter window;
removing the etch protection portion;
forming sidewall spacers (22) in the emitter window; and
filling the emitter window with an emitter material (24).

2. The method of claim 1, wherein said etch protection portion (30, 32, 34) comprises a nitride layer (32).

3. The method of claim 1 or 2, wherein the step of forming a base layer (14, 14') comprises epixially growing:
- a first undoped Si layer over the substrate (10);
- an undoped SiGe:C collector-base spacer on the first undoped Si layer;
- a boron-doped SiGe:C base on the collector-base spacer;
- an undoped SiGe:C base-emitter spacer on the base; and
- a doped Si emitter cap on the base-emitter spacer.

4. The method of any of claims 1-3, further comprising forming a patterned nitride layer (13) over the substrate (10) prior to the formation of the layer stack, said patterned nitride layer leaving the active region (11) exposed.

5. The method of any of claims 1-4, wherein the insulating layer (18) is an undensified tetraethyl orthosilicate (TEOS) layer.

6. The method of claim 5, wherein said oxidizing step simultaneously densifies the TEOS layer (18).

7. The method of any of claims 1-6, wherein the step of forming sidewall spacers (22) comprises depositing oxide spacers in the emitter window (40).

8. The method of any of claims 1-7, wherein said oxidizing step comprises exposing the resultant structure to a wet oxidation recipe at a temperature in the range of 700-750°C.

9. A bipolar transistor comprising:
a substrate (10) including a first isolation region (12) separated from a second isolation region (12) by an active region (11) comprising a collector region; and
a layer stack over said substrate, said layer stack comprising a base layer (14, 14'), a polysilicon layer (16) over said base layer and an insulating layer (18) over the polysilicon layer, said layer stack comprising a emitter window (40) over the active region filled with an emitter material (24), the emitter material being separated from the layer stack by sidewall spacers (22), wherein the regions (16') of the polysilicon layer (16) facing the base window have been oxidized.

10. The bipolar transistor of claim 9, wherein the emitter material (24) comprises doped polysilicon.

11. The bipolar transistor of claim 9 or 10, wherein the base layer (14, 14') comprises:
a first undoped Si layer over the substrate (10);
- an undoped SiGe:C collector-base spacer on the first undoped Si layer;
- a boron-doped SiGe:C base on the collector-base spacer;
- an undoped SiGe:C base-emitter spacer on the base; and
- a doped Si emitter cap on the base-emitter spacer

12. The bipolar transistor of any of claims 9-11, wherein the insulating layer (18') comprises densified TEOS.

13. The bipolar transistor of any of claims 9-12, wherein the oxidized regions (16') of the polysilicon layer (16) have a shape ranging from a rectangular shape to a half moon shape.

14. The bipolar transistor of any of claims 9-13, wherein the sidewall spacers (22) are formed by a thin oxide layer.

15. An integrated circuit comprising one or more bipolar transistors according to any of claims 9-14.
